# EUROPÄISCHE PATENTSCHRIFT

(11) **EP 3 721 244 B1**
(45) Veröffentlichungstag und Bekanntmachung des Hinweises auf die Patenterteilung: **30.08.2023**
(21) Anmeldenummer: 18807613.7
(22) Anmeldetag: 21.11.2018
(51) Int. Cl.: G01R 33/09, G01D 5/14, G01R 33/00, G01R 33/07

(54) **MAGNETFELDSENSOR**
MAGNETIC FIELD SENSOR
CAPTEUR DE CHAMP MAGNÉTIQUE

(30) Priorität: 05.12.2017 DE 102017128889
(43) Veröffentlichungstag der Anmeldung: 14.10.2020
(73) Patentinhaber: Sensitec GmbH, 35578 Wetzlar (DE)
(72) Erfinder: GEBHARDT, Carola, 35614 Aßlar (DE)
(74) Vertreter: Spachmann, Holger
(86) Internationale Anmeldenummer: PCT/EP2018/082067
(87) Internationale Veröffentlichungsnummer: WO 2019/110304

(56) Entgegenhaltungen:
- EP-A2- 0 324 105
- DE-A1-102011 001 422
- DE-T5-112015 003 432
- JP-A- H0 694 747
- US-A- 5 250 925
- US-A1- 2003 071 615

## Beschreibung

Die Erfindung geht aus von einem Magnetfeldsensor zur Messung eines veränderlichen Magnetfelds, insbesondere für einen Bewegungs- oder Lagesensor, die einen sehr geringen Messabstand zu einer Sensoroberfläche aufweist, so dass extrem kurze Distanzen zum Magnetfeld erzeugenden Sensormagnet möglich sind.

### STAND DER TECHNIK

Aus dem Stand der Technik sind zahlreiche Magnetfeldsensorkonfigurationen bekannt, bei denen ein Sensormagnet, der sowohl ein permanentmagnetischer als auch ein stromangeregter Elektromagnet sein kann, nah an einem Magnetfeldsensorchip bewegt wird, d.h. in Abständen geringer als 5 mm. Dies ist insbesondere bei schwachen Magnetfeldern, aber auch bei hochgenauen Sensoranwendungen, beispielsweise bei Bewegungs- oder Lagesensoren, notwendig.

Bedingt durch den Aufbau vorbekannter Magnetfeldsensoren mit einem magnetoresistiven Sensorchip und einem, den Sensorchip aufnehmenden, flächigen Sensorträger, der zur elektrischen Kontaktierung dient, und auf den eine Auswerteelektronik oder Anschlusselemente angeordnet sein können, lassen sich mittels der bisherigen Chip-on-Board-Technologie (COB) minimale Abstände zu dem Sensormagneten von bis zu 500 µm erreichen. Dabei wird der magnetoresistive Sensorchip auf dem Sensorträger direkt befestigt, oder mittels eines Zwischenträgers auf dem Substrat des Sensorträgers aufgebracht. In der Regel wird ein Sensormagnet entlang derjenigen Oberfläche des Sensorträgers, auf dem der Sensorchip aufgebracht ist, bewegt.

Auf dem Sensorträger sind typischerweise Bondpads angeordnet, die elektrische Komponenten des Sensorchips über Bonddrähte kontaktieren. Durch das Bondingsystem mittels Drähten und deren Loop-Höhen, d. h. deren bauliche Höhe für die Verbindung zwischen den Bondpads und dem Sensorchip, sind technologische Mindesthöhen gegeben, die nicht unterschritten werden können. Zum elektrischen und mechanischen Schutz des Sensorchips auf dem Sensorträger wird eine sogenannte Passivierung über dem Sensorchip aufgebracht. Dies ist eine Elektronic-Packaging-Maßnahme, wobei in der Regel ein Eingie-ßen des Sensorchips in einen Kunstharz- oder Kunststoffmantel mittels sogenannter Glob-Top-Technologie eingesetzt wird. Insbesondere bei der Chip-on-Board-Montage wird ein Epoxidharz auf den Sensorchip und die Bonddrähte aufgebracht, um eine mechanisch stabile und vor allen Umgebungseinflüssen schützende Außenhülle zu bilden.

Eine Passivierung mittels Glob Top kann maximale Bauhöhen in der Größenordnung von ca. 200 µm ermöglichen, jedoch können keine geringeren Mindesthöhen erreicht werden. Weiterhin müssen bei derart dünnen Passivierungsschichten auf dem Sensorchip Einschränkungen, insbesondere hinsichtlich der Zuverlässigkeit, Langlebigkeit und Temperaturempfindlichkeit hingenommen werden.

Wird ein Messfeld produzierender Sensormagnet in unmittelbarer Nähe über die Oberfläche des Sensorträgers bewegt, kann dieser fast unmittelbar über die Passivierungsschicht hinweggeführt werden. Um dabei einen mechanischen Abrieb zu vermeiden und eine Führungsoberfläche für den Sensormagneten zu bilden, kann zusätzlich auf die Glob-Top-Schicht eine Gleitschicht aufgebracht werden, die aber weiterhin einen Abstand zwischen der Oberfläche des Sensorchips und dem Sensormagneten erhöht. Des Weiteren können durch eine mechanische Streifbewegung vom Sensormagnet über einer Oberfläche der Passivierungsschicht elektrostatische Aufladungen entstehen, so dass die ESD-Empfindlichkeit (Electrostatic Discharge) erhöht wird, die eine potenzielle Schädigung des Sensorchips hervorrufen kann. Denn wenn ein Sensormagnet sehr dicht über die Passivierungsschicht geführt wird oder in Kontakt mit der Passivierungsschicht kommt, können Aufladungen entstehen, die zu Spannungsdurchschlägen führen können, und die Schädigungen elektrischer Strukturen auf dem Sensorchip oder der damit in Kontakt stehenden Auswerteelektronik bewirken können.

Als Oberfläche auf der Glop-Top-Passivierungsschicht haben sich sogenannte tribologische Schichten, die in der Regel aus Kunststoff bestehen, durchgesetzt, die einen reibungsmindernden Effekt haben. Diese können sich allerdings bei Reibungskontakt aufladen und bieten somit keinen Schutz vor ESD-Einwirkungen, sondern fördern diese sogar. Insoweit werden in den bestehenden Techniken zum Aufbau eines Magnetfeldsensors nur ein minimaler Abstand zu einem Sensormagneten >200 µm erreicht, wobei geringere Distanzen zu einer Beeinträchtigung von Lebensdauer und/oder Fehleranfälligkeit führen.

Beispielsweise ist aus dem Stand der Technik in der DE 10 2014 107 262 A1 eine Magnetfeldsensoranordnung bekannt, bei der eine Reihe von Sensorchips an der Kante eines PCBs (Printed Circuit Board-Schaltungsplatine) angeordnet sind, um ein Sensormagnetfeld für eine berührungslose Wirbelstromprüfung messen zu können. Hierbei wird durch die Kantenanordnung versucht, den Sensorchip möglichst nahe an die Oberfläche eines zu messenden Werkstücks heranzubringen, jedoch sind die Mindestabstände bedingt durch die mechanisch schützende Passivierungsschicht und eine etwaige tribologische Gleitschicht vorbestimmt, so dass die Sensorempfindlichkeit durch den minimalen Bauabstand zur Werkstückoberfläche begrenzt ist.

In der DE 10 2011 001 422 A1 ist ein dreidimensionaler Sensor für Messungen von Magnetfeldern. Die drei Sensoren sind auf einem aus einem kristallinen Silizium bestehenden Substrat angeordnet. In das Substrat wird eine Vertiefung eingebracht, die eine Tiefe von etwa 300 µm aufweist. Die Tiefe verfügt über eine Ebene und Seitenwände, wobei auf der Ebene die Sensoren flächig liegend angeordnet sind, um das Magnetfeld in x-Achse und y-Achse zu messen. An einer Seite der Vertiefung ist in der Vertiefung ein Graben geätzt, in welcher in senkrechter Aufstellung ein Trägersubstrat mit einen darauf montierten dritten Sensor angeordnet ist, der in einer Grube des Trägersubstrat ausgebildet ist, um das Magnetfeld in z-Achse zu erfassen. Somit befindet sich der dritte Sensor in senkrechter Ausrichtung zu der Ebene bzw. zu den Sensoren. Außerdem sind die drei Sensoren von Unterseiten des Substrats elektrisch kontaktierbar.

In der DE 101 64 482 A1 ist eine Vorrichtung zur Sensierung eines Magnetfeldes und Stromsensor dargestellt. Ein Substrat bildet eine Basis der Vorrichtung, wobei das Substrat als Halbleitersubstrat, insbesondere Siliziumsubstrat ausgebildet ist. Oberhalb einer Passivierungsschicht ist eine Kunststoffschicht vorgesehen. Ein Magnetfeldsensor ist in oder auf dem Substrat angeordnet. Weiterhin kann der Magnetfeldsensor mindestens teilweise in einer Ebene mit der Kunststoffschicht derart vorgesehen sein, dass wenigstens eine Ebene parallel zu der Substratebene sowohl die Kunststoffschicht als auch den Magnetfeldsensor schneidet.

In der DE 103 08 890 A1 ist eine Gehäusestruktur für eine Lichtemissionsdiode und Verfahren zu dessen Herstellung offenbart. Ein Träger ist mit einer Vertiefung vorgesehen, die aus einer Bodenfläche und zwei Seitenwänden besteht. In der Vertiefung ist eine Lichtemissionsdiode angeordnet, wobei zwischen der Lichtemissionsdiode und der Bodenfläche ein Substrat vorgesehen ist. Weiterhin kann die Vertiefung eine Tiefe als solche von 10 mm aufweisen. Somit kann bessere Durchstrahlung der Lichtemissionsdiode erfolgen.

Die US 5 250 925 A beschreibt eine magnetfeldempfindliche Vorrichtung zur Erfassung einer Drehzahl eines verzahnten Erregerrades für ein Anti-Blockier-System eines Fahrzeugs. Eine Sensoreinheit der magnetfeldempfindlichen Vorrichtung kann in einem Gehäuse angebracht sein, das neben dem Erregerrad angeordnet ist. Dadurch, dass die Sensoreinheit in der Nähe des Erregerrads angeordnet ist, kann erreicht werden, dass ein Abstand bzw. ein Luftspalt zwischen der Sensoreinheit und dem Erregerrad von 0,5 bis 1,0 Millimeter um 0,2 bis 0,7 Millimeter verringert werden kann. Um den Magnetwiderstand und die Leitungen zu halten, kann ein Thermofixierungselement gegen eine Innenfläche und die Leitungen sowie eine Schulter angeordnet sein, das sich radial von einer Innenseite einer Verpackung erstreckt.

In der DE 11 2015 003432 T5 ist eine Magnetsensorvorrichtung, in der ein AMR-Chip umgefasst ist, beschrieben. Mittels der Magnetsensorvorrichtung wird eine bewegliche magnetische Komponente, die von einem Magneten erzeugt und von einem beweglichen Messobjekt verändert wird, von einer Oberseite des AMR-Chips erfasst. Der AMR-Chip ist an einer Oberseite eines Jochs des Magneten als Substratträger angeordnet. Eine Platine ist an der Oberseite des Jochs fixiert und umgibt den AMR-Chip. Die Platine ist mit einer Stromversorgungsleitung, einer Massenleitung und einer Signalleitung des AMR-Chips verbunden, so dass der AMR-Chip von der Oberseite des Jochs aus elektrisch kontaktbar ist. Zum Einschließen des AMR-Chips kann die Platine und der AMR-Chips mittels einer Metall-Abschirmplatte abgedeckt werden.

Die EP 0 324 105 A2 zeigt eine Vorrichtung zum Erfassen eines Magnetfeldes in einem geringen Abstand zu einem magnetfeldabhängigen Widerstand angeordneten, gezahnten ferromagnetischen Teils. In der Vorrichtung befindet sich der magnetfeldabhängige Widerstand auf einem Substrat, wobei am Widerstand eine Abstandsplatte und ein Permanentmagnet hintereinander vorgesehen sein können.

Die JP H06 94747 A stellt eine Magnetsensorvorrichtung dar, die ein Sensorelement aufweist. Das Sensorelement kann mit einem Gehäuse abgedeckt werden. Ein Sensorrotor ist mit einem an dessen Außenumfang angeordneten Zahnrad vorgesehen, wobei der Sensorrotor ein magnetischer Körper ist. Das Sensorelement ist zum Messen eines Magnetfelds des Sensorrotors näher an dem Zahnrad angeordnet.

In der US 2003/071615 A1 ist eine Sensorvorrichtung zur zerstörungsfreien Materialmessung gezeigt, wobei die Sensorvorrichtung zum Erfassen eines Magnetfelds eine Vielzahl von Sensorelementen und eine Primärwicklung aus parallelen leitenden Segmenten aufweist, In der Sensorvorrichtung ist zumindest ein Sensorelement als magnetoresistiver Sensor ausgebildet. Um eine vollständige Abdeckung bereitzustellen, können die Sensorelemente entlang einer Länge einer Primärschleife versetzt sein.

Ausgehend von dem vorgenannten Stand der Technik ergibt sich die Aufgabe der vorliegenden Erfindung, einen Magnetfeldsensor vorzuschlagen, der einen sehr geringen Abstand zu einem Sensormagnet in einer Größenordnung < 200 µm, insbesondere in einer Größenordnung von 100 µm bis 30 µm, bereitstellt.

Diese Aufgabe wird durch einen Magnetfeldsensor, ein Herstell- und ein Messverfahren nach den unabhängigen Ansprüchen gelöst.

Vorteilhafte Ausbildungen der Erfindung sind Gegenstand der Unteransprüche.

### OFFENBARUNG DER ERFINDUNG

Die Erfindung geht aus von einem Magnetfeldsensor zur Messung eines veränderlichen Magnetfelds, insbesondere für einen Bewegungs- oder Lagesensor, umfassend einen magnetoresistiven Sensorchip und einen, den Sensorchip tragenden, flächenförmigen Sensorträger mit einer Oberseite und einer Unterseite, wobei die Oberseite des Sensorträgers eine Ausnehmung oder Vertiefung aufweist, in der der Sensorchip angeordnet ist, wobei der Sensorchip von der Oberseite aus über, auf dem Sensorchip vorgesehene, Anschlusspunkte elektrisch kontaktierbar ist, und der Sensorchip über die Unterseite ein zu messendes Magnetfeld, das von einem erzeugenden Sensormagnet, der entlang der Unterseite des Sensorträgers führbar ist, erzeugt wird, aufnimmt.

Es wird vorgeschlagen, dass die Ausnehmung mit einem Schutzmantel zur mechanischen Stabilisierung und Passivierung des Sensorchips ausgefüllt und / oder überdeckt ist, die Plan mit der Oberseite abschließt oder über die Oberseite übersteht, wobei der Sensorchip in die Ausnehmung horizontal eingesetzt ist, so dass ein Magnetfeld in x- und / oder y-Richtung durch den Sensorchip in der Ebene des Sensorträgers erfassbar ist.

Mit anderen Worten betrifft die Erfindung einen Magnetfeldsensor, der einen magnetoresistiven Sensorchip umfasst, wobei der Sensorchip auf einem flächenförmigen Sensorträger, beispielsweise einem PCB, einem Halbleitersubstrat oder einem sonst wie gestalteten flächenförmigen Aufnahmeträger des Sensorchips ausgeformt ist. Der Sensorchip ist im Sensorträger aufgenommen, und beispielsweise mit Bonddrähten elektrisch mit Bondpads des Sensorträgers kontaktierbar. Der Sensorchip ist dazu ausgelegt, ein Sensormagnetfeld eines Sensormagneten, der von einer Unterseite des Sensorträgers auf den Magnetfeldsensor einwirkt, aufzunehmen. Der Sensorchip ist von der Oberseite des Sensorträgers kontaktierbar und wird in der Regel von der Oberseite auf den Sensorträger aufgesetzt und befestigt. Um einen extrem geringen Abstand zum Sensormagnet bereitzustellen, ist von der Oberseite des Sensorträgers eine Ausnehmung oder Vertiefung vorgesehen, in der der Sensorchip angeordnet und befestigt ist.

Eine Ausnehmung ist im Sinne der Erfindung ein Durchbruch durch den Sensorträger, so dass dieser gewissermaßen ein Loch ausweist, in dem der Sensorchip eingesetzt und beispielsweise mittels eines Packaging-Verfahrens, beispielsweise einer Passivierungsschicht mittels Glob Top in dem Loch eingegossen und im Sensorträger befestigt ist. Alternativ kann der Sensorträger eine Vertiefung aufweisen, d. h. einen flächenmäßig begrenzten Bereich mit einer geringeren Dicke des Sensorträgers, in der der Sensorchip aufgenommen und befestigt ist, so dass in dieser Vertiefung der magnetoresistive Sensorchip näher an dem auf der Unterseite vorbeistreichenden Sensormagneten angeordnet sein kann.

In einer vorteilhaften Ausführungsform kann der Sensorchip von der Oberseite auf den Sensorträger aufgesetzt und befestigt werden. Somit kann ein extrem geringer Abstand zum Sensormagnet bereitgestellt werden.

In einer vorteilhaften Ausführungsform kann die Unterseite des Sensorträgers mit einer Trägerfolie und/oder einer tribologischen Schutzschicht beschichtet sein, wobei die Trägerfolie bevorzugt eine Kaptonfolie ist. Eine Trägerfolie kann insbesondere im Laufe des Herstellprozess temporär eingesetzt werden, um im Falle einer Ausnehmung des Sensorträgers auf die Unterseite des Sensorträgers geklebt zu werden, so dass der Sensorchip auf die Kaptonfolie aufgesetzt, hiernach elektrisch mit Kontaktierungen des Sensorträgers verbunden und schließlich passiviert, insbesondere mittels Glob Top eingegossen werden kann. Hiernach kann die Kaptonfolie weiterhin auf der Unterseite verbleiben, definiert allerdings einen Mindestabstand zum Sensormagneten, oder kann entfernt werden, so dass eine sehr geringe Distanz zwischen Sensorchip und Sensormagnet erreicht werden kann.

Alternativ oder zusätzlich kann eine tribologische Schutzschicht auf der Unterseite im Bereich der Platzierung des Sensorchips auf dem Substratträger aufgebracht werden. Die tribologische Schutzschicht kann eine Kunststoffschicht sein, die einen mechanischen Abrieb verhindert und eine erhöhte Gleitfähigkeit bietet, so dass ein Sensormagnet in mechanischem Kontakt zur Unterseite des Substratträgers bzw. zur Unterseite des Sensorchips ohne mechanische Beschädigung und mit verringertem Reibungskoeffizienten kontaktflächig entlanggeführt werden kann. Die tribologische Schicht kann eine Dicke von 10 µm oder weniger aufweisen. Der Sensorchip ist derart in der Ausnehmung des Substratträgers aufgenommen und befestigt, dass seine kontaktierbare Oberfläche, die mittels Bonddrähte mit Bondpads auf dem Substratträger kontaktiert sind, in Richtung Oberseite des Substratträgers weisen.

In einer vorteilhaften Weiterbildung kann die Ausnehmung stufenartig ausgebildet sein und einen vertieften Anschlussbereich, der die Bondpads aufnimmt, aufweisen, wobei bevorzugt die Bonddrähte derart innerhalb der Ausnehmung geführt sind, dass sie nicht über die Oberseite des Sensorträgers herausreichen. In dieser Ausführungsform wird vorgeschlagen, einen stufenartig vertieften Anschlussbereich der Bondpads auf dem Substratträger auszubilden, wobei Bonddrähte die Bondpads des Substratträgers mit dem Chip zwischen dem vertieften Anschlussbereich und dem im Substratträger noch tiefer liegenden Sensorchip verbinden. Die Bonddrähte können dabei vorteilhafterweise derart geführt werden, dass sie nicht über die Oberflächenhöhe des Substratträgers hinausreichen, so dass der Sensorchip derart im Substratträger eingebettet ist, dass auf der Oberseite der Substratträgeroberflächen kein Überstand der Bonddrähte entsteht. Hierdurch lassen sich ultradünne Substratträger herstellen, in denen der Sensorchip praktisch im Inneren eingebettet ist, und kein Überstand sowohl auf der Unterseite als auch auf der Oberseite des Substratträgers entsteht. Der vertiefte Anschlussbereich kann beliebig groß ausgeführt sein, und kann insbesondere Platz für sechs Bondpads bereitstellen, um zwei Wheatstone-Messbrücken für einen 2D-Vektorsensor, die durch die magnetoresistiven Widerstände des Sensorchips gebildet werden, kontaktieren zu können. Der vertiefte Anschlussbereich kann an einer, zwei oder drei Seiten anschließend zum Sensorchip ausgebildet sein, um eine möglichst platzsparende Kontaktierung des Sensorchips zu erreichen.

In der vorliegenden Erfindung ist die Ausnehmung mit einem Schutzmantel ausgefüllt und/oder überdeckt der Plan mit der Oberfläche abschließt oder über die Oberseite übersteht, wobei bevorzugt der Schutzmantel ein Glob-Top-Schutzmantel ist. Der Schutzmantel dient zur Passivierung und wird in der Regel durch ein Kunststoffharz oder Epoxidharz gebildet, wobei eine Glob-Top-Passivierung erreicht werden kann, die entweder flächenbündig zur Oberfläche des Sensorträgers oder überlappend über den Ausnehmungsbereich des Sensorträgers übersteht, um eine mechanische Stabilisierung, und Passivierung des Sensorchips erreichen zu können. Insbesondere wenn ein vertiefter Anschlussbereich im Sensorträger vorgesehen ist, kann die Oberseite des Sensorträgers planar mit dem Schutzmantel ausgefüllt sein, um eine ultradünne Ausführung des Magnetfeldsensors zu ermöglichen.

In einer bevorzugten Ausführungsform kann der Sensorchip ein Trägersubstrat umfassen, das in der Ausnehmung bündig mit der Unterseite des Sensorträgers abschließt und die Dicke des Trägersubstrats kann geringer als 100 µm, insbesondere geringer als 50 µm, bevorzugt geringer als 30 µm ausgebildet sein. Somit kann der Sensorträger eine Ausnehmung aufweisen, auf dem der Sensorchip entweder bündig mit der Unterseite des Sensorträgers fluchtet, oder auf einem dünnen Wandungsbereich aufsitzt, dessen Dicke geringer als 100 µm, geringer als 50 µm oder geringer als 30 µm ist. Hierdurch können minimale Distanzen zum Sensormagneten von 100 µm oder weniger erreicht werden, und ein hoher mechanischer Schutz sowie eine definierte Anordnungsoberfläche für den Sensorchip bereitgestellt werden.

In einer bevorzugten Ausführungsform kann ein Sensormagnetfeld erzeugender Sensormagnet entlang der Unterseite des Sensorträgers führbar sein, wobei bevorzugt aus der Unterseite des Sensorträgers eine tribologische Schutzschicht als mechanischer Schutz aufgebracht ist, die sowohl den Reibungskoeffizienten verringert, als auch einen mechanischen Schutz der Unterseite des Sensorchips oder der dünnen Wandung bewirkt, so dass eine hohe Langlebigkeit bei minimalem Sensorabstand erreicht werden kann.

In einem nebengeordneten Aspekt wird ein Herstellverfahren zur Herstellung eines Magnetfeldsensors vorgeschlagen, das folgende Schritte umfasst:
- Erstellung einer Ausnehmung oder Vertiefung ausgehend von der Oberseite des Sensorträgers hin zur Unterseite des Sensorträgers
- zumindest temporäre Befestigung eines Sensorchips in der Ausnehmung oder Vertiefung im Bereich der Unterseite des Sensorträgers, wobei der Sensorchip in die Ausnehmung horizontal eingesetzt wird, so dass ein Magnetfeld in x- und / oder y-Richtung durch den Sensorchip in der Ebene des Sensorträgers erfasst wird
- Bonden des Sensorchips zur elektrischen Kontaktierung mit Bondpads des Sensorträgers
- Zumindest teilweises Eingießen des Sensorchips in der Ausnehmung oder Vertiefung in einem Schutzmantel zur Passivierung.

Mit anderen Worten wird ein Herstellverfahren vorgeschlagen, in dem in einem Substratträger, beispielsweise einem PCB oder einem Chipsubstrat oder einem sonstigen flächigen Träger, eine Ausnehmung, d. h. ein Durchgangsloch oder eine Vertiefung, d. h. ein Bereich mit einer verdünnten Wandstärke in Richtung Unterseite des Substratträgers hergestellt wird, in dem zumindest temporär der Sensorchip befestigt wird, zum Beispiel durch Aufkleben auf einer Trägerfolie, insbesondere einer Kaptonfolie, oder durch mechanisches Einklemmen. Anschließend wird der Sensorchip mit elektrischen Kontakten des Sensorträgers verbunden, insbesondere mittels Bonddrähten mit Bondpads des Sensorträgers verbunden wird, und der Sensorchip abschließend passiviert, d. h. in ein Epoxidharz, Kunststoff oder dergleichen eingegossen und somit mechanisch und elektrisch von der Außenwelt geschützt.

In einer vorteilhaften Weiterentwicklung des Herstellverfahrens kann der Sensorchip zur zumindest temporären Befestigung auf ein auf der Unterseite des Sensorträgers zumindest temporär angebrachten Trägerfolie, insbesondere einer Kaptonfolie, aufgesetzt und fixiert werden. Die Kaptonfolie kann selbstklebend auf die Unterseite des Substratträgers aufgebracht werden, und der Sensorchip kann auf der Kaptonfolie der Ausnehmung platziert werden, hiernach elektrisch verbunden und anschließend eingegossen werden. Die Kaptonfolie kann am Ende des Herstellverfahrens abgezogen werden, so dass die Unterseite des Sensorchips mit der Unterseite des Sensorträgers fluchtet, oder die Kaptonfolie kann zum erweiterten mechanischen Schutz auf der Unterseite verbleiben, und/oder mit einer tribologischen Schutzschicht versehen werden.

In einem vorteilhaften weiteren Ausführungsbeispiel des Herstellverfahrens kann eine tribologische Schutzschicht auf der Unterseite des Sensorträgers aufgebracht werden. Die tribologische Schutzschicht kann sowohl die Unterseite des Sensorträgers als auch den Ausnehmungsbereich des Sensorträgers umfassen, und kann eine Kontaktführung des Sensormagneten auf der Unterseite des Sensorträgers ermöglichen, bei dem mit einem möglichst geringen Reibungskoeffizienten und einem geringen mechanischen Abrieb ein extrem dünner Abstand zwischen Sensormagnet und Sensorchip erreicht werden kann.

In einer vorteilhaften Weiterbildung des Herstellverfahrens kann nach dem Eingießen des Sensorchips zumindest im Bereich um die Ausnehmung die Unterseite des Sensorträgers plan geschliffen werden. Bei der Ausbildung der einer Ausnehmung im Substratträger wird der Sensorchip eingegossen, wobei das Passivierungsmaterial aus der Ausnehmung heraus über die Oberfläche der Unterseite des Sensorträgers herausragen kann. In diesem Fall bietet es sich an, die Unterseite des Sensorträgers plan zu schleifen, auch um den Mindestabstand zum Sensorchip zu verringern.

Auch kann die Unterseite des Sensorchips abgeschliffen bzw. gegrindet werden, um dessen Substratdicke zu verringern, so dass der Abstand zwischen der Substratoberfläche, die magnetoresistive Strukturen trägt, und der Unterseite des Sensorträgers weiterhin zu verringern.

In einer vorteilhaften Weiterbildung des Herstellverfahrens kann die Ausnehmung im Trägersubstrat stufenartig ausgebildet sein, um einen vertieften Anschlussbereich auszubilden, auf dem Bondpads angeordnet werden können, wobei bevorzugt beim Bonden die Bonddrähte derart innerhalb der Ausnehmung geführt sind, dass sie nicht über die Oberfläche des Sensorträgers herausreichen. Durch die Bereitstellung eines stufenartig ausgebildeten Anschlussbereichs entlang einer, zweier oder dreier Seiten des

Ausnehmungsbereichs, in dem der Sensorchip angeordnet ist, kann eine extrem dünne Ausbildung des Sensorträgers und des gesamten Magnetfeldsensors erreicht werden, wobei der Sensorchip praktisch in der Bautiefe des Sensorträgers eingebettet ist, und nicht darüber hinausragt. Dies kann insbesondere bei Anwendung mit extrem geringen Bauhöhen zur Magnetfeldmessung vorteilhaft ausgenutzt werden.

In einem weiteren nebengeordneten Aspekt wird ein Messverfahren unter Verwendung eines Magnetfeldsensors, wie oben beschrieben, vorgeschlagen, wobei ein Sensormagnetfeld entlang der Unterseite des Sensorträgers geführt wird, und die Messsignale des Sensorchips durch eine Auswerteeinrichtung, die auf der Oberseite des Sensorträgers angeordnet ist, aufbereitet und/oder ausgewertet wird. Somit wird ein Komplettsystem eines Magnetfeldsensors vorgeschlagen, wobei im Messverfahren der Sensormagnet unmittelbar oder nur mit geringem Abstand zur Unterseite des Sensorträgers geführt wird, und die Messsignale des magnetoresistiven Sensorchips auf einer auf der Oberseite des Sensorträgers verbauten Auswerteeinrichtung ausgewertet wird. Somit können ein sehr kompaktes Messverfahren und ein kompakter Magnetfeldsensor bereitgestellt werden.

### ZEICHNUNGEN

Weitere Vorteile ergeben sich aus der vorliegenden Zeichnungsbeschreibung.

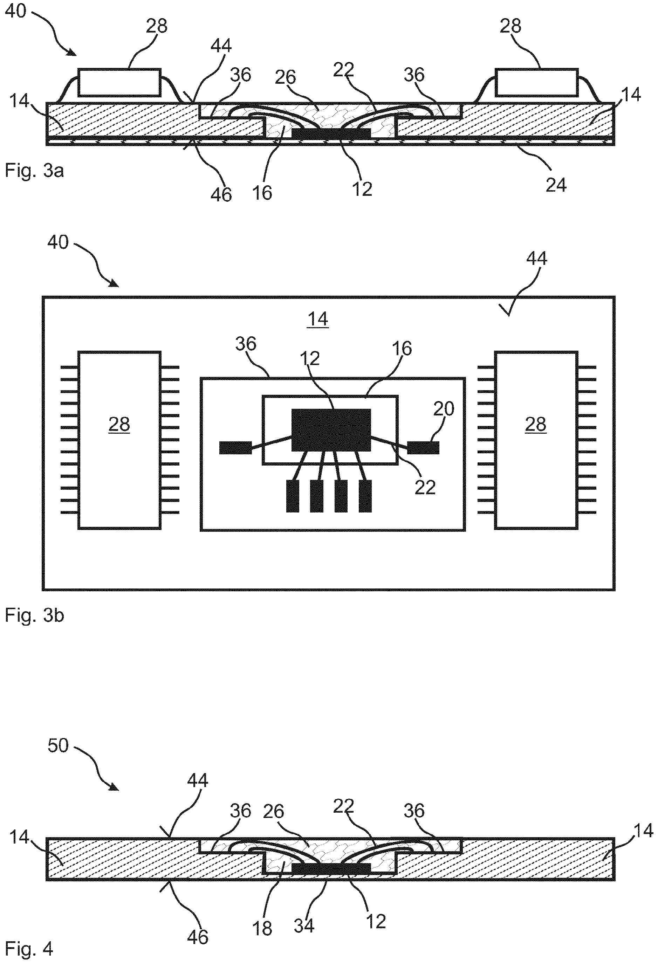

In den Zeichnungen sind Ausführungsbeispiele der Erfindung dargestellt, mit Ausnahme von Fig. 4, welche eine alternative Sensorkonfiguration mit einer Vertiefung im Substratträger zeigt, anstatt einer Ausnehmung entsprechend der vorliegenden Erfindung. Die Zeichnung, die Beschreibung und die Ansprüche enthalten zahlreiche Merkmale in Kombination.

Es zeigen:
- **Fig. 1a, 1b**: eine erste Ausführungsform eines Magnetfeldsensors in einem Querschnitt und in einer Draufsicht auf die Oberseite des Sensorträgers;
- **Fig. 2**: einen Querschnitt durch eine weitere Ausführungsform eines Magnetfeldsensors;
- **Fig. 3**: eine Schnittdarstellung in einer Draufsicht auf eine Oberseite eines Magnetfeldsensors einer weiteren Ausführungsform der Erfindung;
- **Fig. 4**: einen Querschnitt eines Magnetfeldsensors einer alternative Konfiguration;

- **Fig. 5**: beispielhaft ein Messverfahren mittels eines Magnetfeldsensors nach einer Ausführungsform der Erfindung,
- **Fig. 5a, 5b**: eine Ausführungsform eines Messverfahrens unter Verwendung verschiedener Magnetfeldsensoren entsprechend der Erfindung.

In den Figuren sind gleichartige Elemente mit gleichen Bezugszeichen beziffert.

Die Figuren zeigen lediglich Beispiele und sind nicht beschränkend zu verstehen.

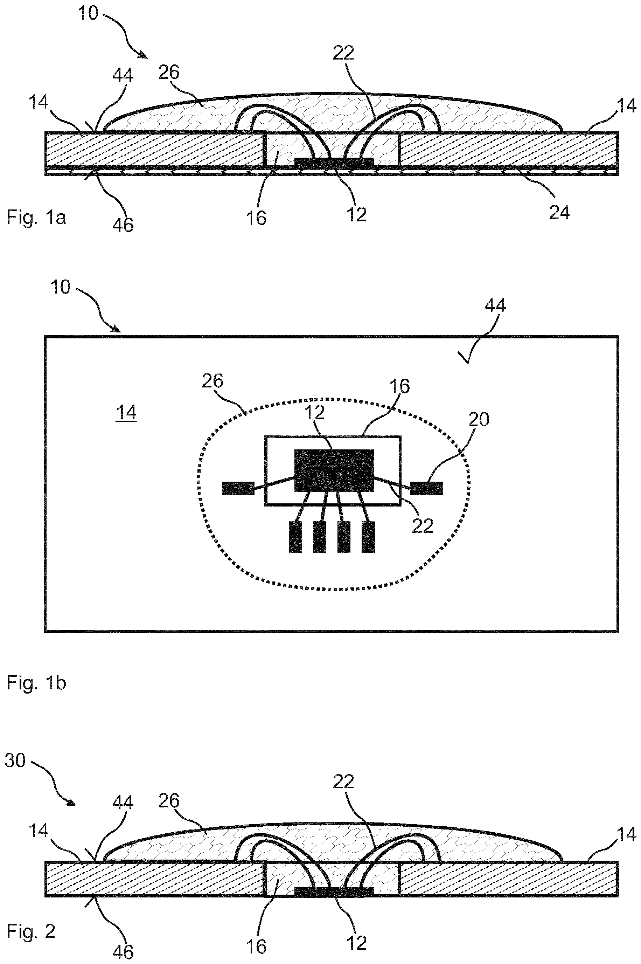

Die Fig. 1a und 1b zeigen ein erstes Ausführungsbeispiel 10 eines Magnetfeldsensors gemäß der Erfindung. In der Fig. 1a ist ein Querschnitt und in der Fig. 1b eine Draufsicht auf einen, einen Sensorchip 12 einbettenden Sensorträger 14, dargestellt. Der Sensorträger 14 kann als PCB (Schaltungsplatine) oder als Chipsubstrat ausgebildet sein. Der Sensorchip 12 kann als magnetoresistiver Sensorchip, insbesondere als magnetoresistive Wheatstone-Messbrückenschaltung für die Bestimmung einer oder mehrerer Vektorkomponenten eines Magnetfelds ausgebildet sein, die in der Lage ist, ein zumindest eine Komponente eines Magnetfelds in unmittelbarer Nähe richtungssensitiv oder omnidirektional messen und deren Größe bestimmen zu können. Der Sensorchip kann auf einer HALL-, AMR-, GMR-, TMR- oder sonstiger magnetoresistiver Technologie beruhen.

Auf dem Sensorträger 14 sind nicht dargestellte weitere elektrische Verbindungen als Spannungsversorgung und Abgriff von Sensorwerten angeordnet. Die elektrische Kontaktierung zwischen Sensorchip 12 und Sensorträger 14 erfolgt über Bonddrähte 22, die Anschlusspunkte auf dem Sensorchip 12 mit Bondpads 20 auf dem Sensorträger 14 verbinden. Ausgehend von den Bondpads 20 sind weitere nicht dargestellte elektrische Verbindungen zu einer externen Auswerteelektronik vorgesehen. So können beispielsweise für einen 2D-Sensor zwei Bondpads 20 für eine Spannungsversorgung sowie vier weitere Bondpads für den Abgriff von Sensorwerten für eine X- und Y-sensitive Magnetfeldkomponente in der Ebene des Sensorträgers sein, die durch zwei um 90° gedrehte Wheatstone-Messbrücken auf dem Sensorchip 12 messbar sind, vorgesehen sein, um eine in der Ebene des Sensorträgers 14 gerichtete Magnetfeldkomponente richtungsabhängig bestimmen zu können. Daraus kann beispielsweise durch eine Arcustangensoperation ein Winkel eines Magnetfelds in der Ebene des Sensorträgers 14 bestimmt werden.

Der Sensorchip 12 ist in einer Ausnehmung 16 des Sensorträgers angeordnet. Die Ausnehmung kann als kreisrundförmiges oder, wie in diesem Beispiel dargestellt, rechteckförmiges Loch im Sensorträger 14 ausgeformt sein. Die Ausnehmung 16 kann gleichfalls die Form eines Langschlitzes aufweisen, um beispielsweise auf einer vordefinierten Länge eine Magnetfeldkomponente in Form eines Zeilenscanners abnehmen zu können.

Zum Schutz des Sensorchips 12 und der Bonddrähte 22 sowie Bondpads 20 sind die Ausnehmung und ein darüberliegender Bereich auf der Oberfläche des Sensorträgers 14 mit einem Schutzmantel 26, beispielsweise einem Epoxidharz mittels einer Glob-Top-Passivierung versehen. Auf der Unterseite des Sensorträgers 14 ist eine Trägerfolie 24, beispielsweise eine Kaptonfolie aufgebracht, auf dem zumindest temporär während der Montage der Sensorchip 12 abgelegt und befestigt wird, und die nachfolgend als Schutzschicht für die mechanische Abnutzung und beispielsweise mittels tribologischer Eigenschaften zur verminderten Gleitreibung eines Sensormagneten dient. Die Dicke der Trägerfolie 24 bestimmt gleichzeitig den minimalen Abstand zwischen Sensorchip 12 und einem Sensormagneten, der in diesem Beispiel nicht dargestellt ist.

In der Fig. 2 ist entsprechend zur Ausführungsform der Fig. 1 ein weiteres Ausführungsbeispiel 30 eines Magnetfeldsensors dargestellt. Dieser entspricht im Wesentlichen dem Aufbau des Ausführungsbeispiels 10 der Figur 1a, 1b. Allerdings ist auf der Unterseite des Sensorträgers 46 eine Trägerfolie 24 vorgesehen. Diese mag zwar im Herstellungsprozess kurzfristig angebracht worden sein, um den Sensorchip 12 temporär zu befestigen, die elektrische Verdrahtung mittels Bonddrähten 22 zum Sensorträger 14 herzustellen, und anschließend entfernt werden. Somit ist der Sensorchip 12 lediglich durch den Schutzmantel 26 in der Ausnehmung 16 eingebettet, und liegt in Richtung der Unterseite des Sensorträgers 14 praktisch offen oder lediglich durch eine hauchdünne Schicht glob-top-geschützt. Hierdurch ist ein extrem minimaler Abstand von wenigen Mikrometern zu einem Sensormagneten möglich.

In den Figuren 3a, 3b ist ein weiteres Ausführungsbeispiel 40 eines Magnetfeldsensors dargestellt. Die Fig. 3a zeigt einen Schnitt und die Fig. 3b eine Draufsicht auf den Sensorträger 14 mit dem eingebetteten Sensorchip 12. Im Gegensatz zu den in den Fig. 1a, 1b und 2 dargestellten Ausführungsformen 10, 30 ist in dieser Ausführungsform 40 in der Ausnehmung 16 ein stufenförmiger vertiefter Anschlussbereich 36 vorgesehen, der in der Höhe gegenüber dem der Oberseite 44 des Sensorträgers stufenartig nach unten versetzt ist und auf dem Pads 20 angeordnet sind. Bonddrähte 22 verbinden elektrische Anschlusspunkte des Sensorchips 12 mit den Bondpads 20 auf dem vertieften Anschlussbereich 36 des Sensorträgers 14. Hierdurch ist es möglich, durch geschickte Führung der Bonddrähte 22 eine Bauhöhe sowohl des Sensorchips 12 als auch der elektrischen Verbindung zu den Bondpads 20 herzustellen, die nicht über die Oberseite 44 des Sensorträgers 14 hinausreicht. Eine Passivierung mittels eines Schutzmantels 26, beispielsweise Glob Top, füllt sowohl den stufenartigen Anschlussbereich 36 als auch die Ausnehmung 16 auf und umhüllt somit den Sensorchip 12 zumindest von der Oberseite und den Seitenbereichen, als auch die Bondpads 20 und Bonddrähte 22.

In der Ausführungsform 40 kann mittels des vertieften Anschlussbereichs 36 ein Magnetfeldsensor geschaffen werden, bei denen der gesamte Sensorchip 12 mit Verdrahtung eine Bauhöhe erreicht, die nicht höher als bis zur Oberseite 44 des Sensorträgers 14 reicht. Somit kann ein extrem dünnwandiger Magnetfeldträger erreicht werden, der insbesondere bei Messaufgaben in räumlich eng begrenzten Bereichen eingesetzt werden kann. Beispielhaft ist hierbei eine externe Schaltung auf dem Sensorträger 14 mittels elektronischen Bauelementen 28 dargestellt, die eine elektrische Verbindung mit den Bondpads 20 aufweisen können.

Im Ausführungsbeispiel 40 ist analog zum Ausführungsbeispiel 10 auf der Unterseite 46 des Sensorträgers 14 eine Trägerfolie 24 aufgebracht, die tribologische Eigenschaften aufweisen kann und einen Schutz für die Unterseite des von der Oberseite und von den Seitenseiten her umgossenen Sensorchips 12 bereitstellt.

In der Fig. 4 ist analog zur Fig. 2 eine alternative Konfiguration 50 eines Magnetfeldsensors dargestellt, welcher nicht unter den Schutzumfang der vorliegenden Erfindung fällt. Bei besagter Alternative handelt es sich um einen Magnetfeldsensor, der in seinem Aufbau dem Ausführungsbeispiel 40 ähnelt, und ebenfalls einen vertieften Anschlussbereich 36 aufweist. Im Unterschied zu den vorhergehenden Ausführungsbeispielen weist allerdings der Magnetfeldsensor 50 keine Ausnehmung 16, sondern eine Vertiefung 18 im Sensorträger auf, so dass ein dünner Wandungsbereich 34 im Sensorträger die Unterseite der Vertiefung 18 begrenzt. Die Breite dieses dünnen Wandungsbereichs des Sensorträgers 14 bestimmt somit einen minimalen Abstand zu einem Sensormagneten und dient als Auflagefläche des Sensorchips 12. Der Sensorchip 12 ist auf diesem dünnen Wandungsbereich 34 während der Herstellung aufgesetzt, und Bonddrähte 22 kontaktieren diesen mit Bondpads 20 in dem vertieften Anschlussbereich 36. Auch hier ist diese Vertiefung 18 mittels einer Glob-Top-Passivierung 26 ausgefüllt, so dass der Sensorchip und die elektrische Verbindung vollständig ummantelt sind. Hierdurch ist ein erhöhter mechanischer Schutz und Passivierung gegeben, wobei die Herstellung des dünnen Wandungsbereichs 34 beispielsweise durch ein 3-D-Druckverfahren zum Aufbau des Sensorträgers 14 erreicht werden kann. Die Unterseite 46 des Sensorträgers 14 ist homogen ausgebildet, so dass eine durchgehende Gleitschicht für einen Sensormagneten bereitgestellt werden kann.

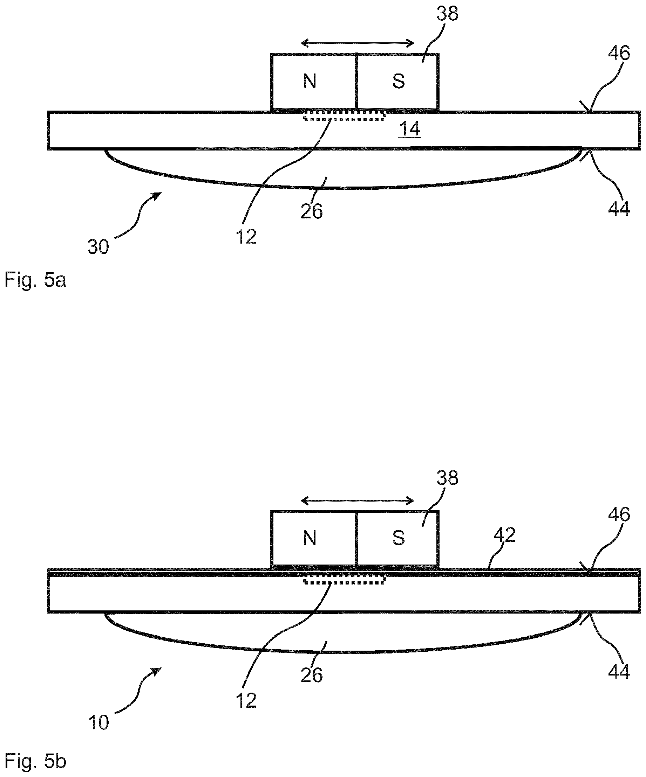

In den Figs. 5a und 5b ist eine Anwendung eines Ausführungsbeispiels 30 oder 10 zur Messung einer Linearbewegung eines Sensormagneten 38 dargestellt. Der Sensormagnet 38 bewegt sich entlang der Unterseite 46 des Sensorträgers. Der Sensorchip 12 ist in einer Ausnehmung des Sensorträgers 14 eingebettet und passiviert. Hierzu kann beispielsweise eine Passivierungsschicht 26 der Oberseite 44 des Sensorträgers 14, die im bestimmungsgemäßen Gebrauch vom Sensormagneten 38 weg weist, geschützt sein. Der Sensormagnet 38 bewegt sich in flächigem Kontakt mit der Unterseite 46 des Sensorträgers 14, wie in Fig. 5a dargestellt. Zur Verringerung des Reibungswiderstandes kann auf der Unterseite 46 eine tribologische Schutzschicht 42, die beispielsweise auch durch eine Trägerfolie 24 bereitgestellt werden kann, aufgebracht sein. Dies erhöht zwar den minimalen Abstand zwischen Sensormagnet 38 und Sensorchip 12, kann jedoch im Bereich von 10 µm bis 30 µm ausgebildet sein, und verbessert den mechanischen Schutz sowie verringert die Reibungswirkung, so dass auch kleinste Magnetfeldschwankungen von dem Sensorchip 12 aufgenommen werden können, und der Sensormagnet 38 dementsprechend klein, kompakt und mit geringer Feldstärke ausgestattet sein kann.

Der erfindungsgemäße Magnetfeldsensor erreicht einen extrem verringerten Abstand des Sensormagneten 38 zum Sensorchip 12, der deutlich unter 100 µm liegen kann. Der Sensormagnet 38 bewegt sich dabei auf der Unterseite 46 des Sensorträgers 14. Die Chipdicke des Sensorchips 12 definiert den kleinstmöglichen Abstand der magnetoresistiven Widerstandsstrukturen zum Sensormagneten 38. Je nach Bedarf kann auch das Substrat des Sensorchips 12 auf ein verringertes Maß gegrindet, d. h. abrasiv verringert werden, um einen erforderlichen Mindestabstand von 30 µm bis 100 µm zu den magnetoresistiven Strukturen auf dem Chip 12 erreichen zu können.

Der Vorteil des vorgeschlagenen Magnetfeldsensors beruht darin, dass bei bestehenden Sensoranwendungen keine wesentliche Änderung im Layout des Sensorchips 12 oder auch des umgebenden Sensorträgers 14 notwendig ist, lediglich die Anbringungstiefe des Sensorchips auf dem Substratträger wird verändert. Es können Standardchips als Sensorchips 12 verwendet werden, und die vorhandene Chip-on-Board-Technologie kann weiterhin eingesetzt werden, um den Chip 12 mit dem Substratträger 14 elektrisch verbinden zu können. Der Sensorchip 12 ist vertieft oder bündig im Substratträger 14 eingebracht, kann aber auch aus der Ausnehmung auf der Oberseite hinausragen, wobei tribologische Gleitschichten problemlos auf der Unterseite 46 aufgebracht werden können. Der Sensormagnet 38 kann im bestimmungsgemäßen Gebrauch auf flächigen Kontakt mit dem Sensorchip 12 kommen und dennoch sind ESD-Schäden weitgehend ausgeschlossen, da es zu keinen unerwünschten elektrischen Aufladungen aufgrund eines Kontakts durch eine Kunststoff-Packaging-Schicht gibt.

### Bezugszeichenliste

- 10: Erstes Ausführungsbeispiel eines Magnetfeldsensors
- 12: Sensorchip
- 14: Sensorträger / PCB
- 16: Ausnehmung im Sensorträger
- 18: Vertiefung im Sensorträger
- 20: Bondpad
- 22: Bonddraht
- 24: Trägerfolie
- 26: Schutzmantel
- 28: Elektronisches Bauelement / Auswerteeinrichtung
- 30: Zweites Ausführungsbeispiel eines Magnetfeldsensors
- 32: Elektronisches Bauelement / Auswerteeinrichtung
- 34: Dünner Wandungsbereich des Sensorträgers
- 36: Vertiefter Anschlussbereich im Sensorträger
- 38: Sensormagnet

- 40: Drittes Ausführungsbeispiel eines Magnetfeldsensors
- 42: Tribologische Schutzschicht
- 44: Oberseite des Sensorträgers
- 46: Unterseite des Sensorträgers

- 50: Viertes Ausführungsbeispiel eines Magnetfeldsensors

## Patentansprüche

1. Magnetfeldsensor (10, 30, 40, 50) zur Messung eines veränderlichen Magnetfelds, insbesondere für einen Bewegungs- oder Lagesensor, umfassend einen magnetoresistiven Sensorchip (12) und einen, den Sensorchip (12) tragenden, flächenförmigen Sensorträger (14) mit einer Oberseite (44) und einer Unterseite (46), wobei die Oberseite (44) des Sensorträgers (14) eine Ausnehmung (16) in Form von einem Durchbruch durch den Sensorträger (14) aufweist, in der der Sensorchip (12) angeordnet ist, wobei der Sensorchip (12) von der Oberseite (44) aus über, auf dem Sensorchip (12) vorgesehene, Anschlusspunkte elektrisch kontaktierbar ist, und der Sensorchip (12) über die Unterseite (46) ein zu messendes Magnetfeld, das von einem erzeugenden Sensormagnet (38), der entlang der Unterseite (46) des Sensorträgers (14) führbar ist, erzeugt wird, wobei die Ausnehmung (16) mit einem Schutzmantel (26) zur mechanischen Stabilisierung und Passivierung des Sensorchips (12) ausgefüllt und/oder überdeckt ist, die Plan mit der Oberseite (44) abschließt oder über die Oberseite (44) übersteht, **dadurch gekennzeichnet, dass** der Sensorchip (12) in die Ausnehmung (16) horizontal eingesetzt ist, so dass ein Magnetfeld in x- und / oder y-Richtung durch den Sensorchip (12) in der Ebene des Sensorträgers (14) erfassbar ist.

2. Magnetfeldsensor (10, 30, 40, 50) nach Anspruch 1, **dadurch gekennzeichnet, dass** der Schutzmantel (26) ein Glob-Top-Schutzmantel ist.

3. Magnetfeldsensor (10, 30, 40, 50) nach Anspruch 1, **dadurch gekennzeichnet, dass** der Sensorchip (12) von der Oberseite auf den Sensorträger (14) aufgesetzt und befestigt ist.

4. Magnetfeldsensor (10, 30, 40, 50) nach Anspruch 1, **dadurch gekennzeichnet, dass** die Unterseite (46) des Sensorträgers (14) mit einer Trägerfolie (24) und/oder einer tribologischen Schutzschicht (42) beschichtet ist, wobei die Trägerfolie (24) bevorzugt eine Kaptonfolie ist.

5. Magnetfeldsensor (10, 30, 40, 50) nach einem der vorhergehenden Ansprüche, **dadurch gekennzeichnet, dass** die Ausnehmung (16) stufenartig ausgebildet ist, und einen vertieften Anschlussbereich (36) mit Bondpads (20) aufweist, und dass bevorzugt Bonddrähte (22) derart innerhalb der Ausnehmung (16) geführt sind, das sie nicht über die Oberseite (44) des Sensorträgers (14) herausreichen.

6. Magnetfeldsensor (10, 30, 40, 50) nach einem der vorhergehenden Ansprüche, **dadurch gekennzeichnet, dass** der Sensorchip (12) ein Trägersubstrat umfasst, das in der Ausnehmung (16) bündig mit der Unterseite (46) des Sensorträgers (14) abschließt, und die Dicke des Trägersubstrats geringer als 100 µm, insbesondere geringer als 50 µm und bevorzugt geringer als 30 µm ist.

7. Magnetfeldsensor (10, 30, 40, 50) nach einem der vorhergehenden Ansprüche, **dadurch gekennzeichnet, dass** auf der Unterseite (46) des Sensorträgers (14) eine tribologische Schutzschicht (42) als mechanischer Schutz aufgebracht ist.

8. Herstellverfahren zur Herstellung eines Magnetfeldsensors (10, 30, 40, 50) nach einem der vorhergehenden Ansprüche, **gekennzeichnet durch** folgende Schritte:
- Erstellung einer Ausnehmung (16) in Form von einem Durchbruch durch einen Sensorträger (14) ausgehend von der Oberseite (44) des Sensorträgers (14) hin zur Unterseite (46) des Sensorträgers (14);
- Zumindest temporäre Befestigung eines Sensorchips (12) in der Ausnehmung (16) im Bereich der Unterseite (46) des Sensorträgers (14), wobei der Sensorchip (12) in die Ausnehmung (16) horizontal eingesetzt wird, so dass ein Magnetfeld in x- und / oder y-Richtung durch den Sensorchip (12) in der Ebene des Sensorträgers (14) erfasst wird;
- Bonden des Sensorchips (12) mit Bondpads (20) des Sensorträgers (14);
- Ausfüllen und / oder Überdecken der Ausnehmung (16) mit einem Schutzmantel (26) zur mechanischen Stabilisierung und Passivierung des Sensorchips (12), die entweder flächenbündig zur Oberseite (44) des Sensorträgers (14) oder überlappend über den Ausnehmungsbereich des Sensorträgers (14) übersteht.

9. Herstellverfahren nach Anspruch 8, **dadurch gekennzeichnet, dass** der Sensorchip (12) zur zumindest temporären Befestigung auf eine auf der Unterseite (46) des Sensorträgers (14) zumindest temporär angebrachte Trägerfolie (24), insbesondere eine Kaptonfolie, aufgesetzt und fixiert wird.

10. Herstellverfahren nach einem der Ansprüche 8 oder 9, **dadurch gekennzeichnet, dass** ein Trägersubstrat des Sensorchips (12) auf eine Substratdicke geringer als 100 µm, insbesondere geringer als 50 µm und bevorzugt geringer als 30 µm abgeschliffen wird.

11. Herstellverfahren nach einem der Ansprüche 8 bis 10, **dadurch gekennzeichnet, dass** eine tribologische Schutzschicht (42) auf der Unterseite (46) des Sensorträgers (14) aufgebracht wird.

12. Herstellverfahren nach einem der Ansprüche 8 bis 11, **dadurch gekennzeichnet, dass** nach dem Eingießen des Sensorchips (12) zumindest im Bereich um die Ausnehmung (16) die Unterseite (46) des Sensorträgers (14) plangeschliffen wird.

13. Herstellverfahren nach einem der Ansprüche 8 bis 12, **dadurch gekennzeichnet, dass** die Ausnehmung (16) im Trägersubstrat stufenartig ausgebildet wird, um einen vertieften Anschlussbereich (36) auszubilden, auf dem Bondpads (20) angeordnet werden, wobei bevorzugt beim Bonden Bonddrähte (22) derart innerhalb der Ausnehmung (16) geführt werden, dass diese nicht über die Oberseite (44) des Sensorträgers (14) herausreichen.

14. Messverfahren unter Verwendung eines Magnetfeldsensors (10, 30, 40, 50) nach einem der vorgenannten Ansprüche 1 bis 7, **gekennzeichnet dadurch, dass** ein Sensormagnet (38) entlang der Unterseite (46) des Sensorträgers (14) geführt wird, und die Messsignale des Sensorchips (12) durch eine Auswerteeinrichtung (32), die auf der Oberseite (44) des Sensorträgers (14) angeordnet ist, aufbereitet und/oder ausgewertet wird.

## Claims

1. Magnetic field sensor (10, 30, 40, 50) for measuring a variable magnetic field, in particular for a movement sensor or position sensor, comprising a magnetoresistive sensor chip (12) and a flat sensor carrier (14) carrying said sensor chip (12) and having an upper side (44) and an underside (46), wherein the upper side (44) of the sensor carrier (14) has a recess (16) in the form of a penetration through the sensor carrier (14) in which the sensor chip (12) is arranged, wherein the sensor chip (12) is electrically contactable from the upper side (44) via connection points provided on the sensor chip (12), and the sensor chip (12) receives via the underside (46) a magnetic field to be measured which is generated by a generating sensor magnet (38) movable along the underside (46) of the sensor carrier (14), wherein the recess (16) is filled in and/or covered with a protective jacket (26) ending plane with the upper side (44) or protruding above the upper side (44) for mechanical stabilization and passivation of the sensor chip (12), **characterized in that** the sensor chip (12) is inserted horizontally into the recess (16) such that a magnetic field is sensable in the x and / or y direction by the sensor chip (12) in the plane of the sensor carrier (14).

2. Magnetic field sensor (10, 30, 40, 50) according to claim 1, **characterized in that** the protective jacket (26) is a Glob Top protective jacket.

3. Magnetic field sensor (10, 30, 40, 50) according to claim 1, **characterized in that** the sensor chip (12) is positioned on and fastened to the sensor carrier (14) from the upper side.

4. Magnetic field sensor (10, 30, 40, 50) according to claim 1, **characterized in that** the underside (46) of the sensor carrier (14) is coated with a carrier film (24) and/or with a tribological protective layer (42), wherein the carrier film (24) is preferably a Kapton film.

5. Magnetic field sensor (10, 30, 40, 50) according to any of the preceding claims, **characterized in that** the recess (16) is designed step-like and has a deepened connection area (36) with bond pads (20), and **in that** bonding wires (22) are preferably laid inside the recess (16) such that they do not protrude above the upper side (44) of the sensor carrier (14).

6. Magnetic field sensor (10, 30, 40, 50) according to any of the preceding claims, **characterized in that** the sensor chip (12) comprises a carrier substrate which ends flush with the underside (46) of the sensor carrier (14) in the recess (16), and the thickness of the carrier substrate is less than 100 µm, in particular less than 50 µm and preferably less than 30 µm.

7. Magnetic field sensor (10, 30, 40, 50) according to any of the preceding claims, **characterized in that** a tribological protective layer (42) is applied as mechanical protection to the underside (46) of the sensor carrier (14).

8. Manufacturing method for manufacturing a magnetic field sensor (10, 30, 40, 50) according to any of the preceding claims, **characterized by** the following steps:
- creation of a recess (16) in the form of a penetration through a sensor carrier (14) extending from the upper side (44) of the sensor carrier (14) towards the underside (46) of the sensor carrier (14);
- at least temporary fastening of a sensor chip (12) in the recess (16) in the area of the underside (46) of the sensor carrier (14), wherein the sensor chip (12) is inserted horizontally into the recess (16), such that a magnetic field is sensed in the x and / or y direction by the sensor chip (12) in the plane of the sensor carrier (14);
- bonding of the sensor chip (12) to bond pads (20) of the sensor carrier (14);
- filling in and / or covering of the recess (16) with a protective jacket (26) for mechanical stabilization and passivation of the sensor chip (12), which is either flush with the upper side (44) of the sensor carrier (14) or protrudes in overlapping manner beyond the recess area of the sensor carrier (14).

9. Manufacturing method according to claim 8, **characterized in that** the sensor chip (12) is positioned on and fixed to a carrier film (24), in particular a Kapton film, at least temporarily attached to the underside (46) of the sensor carrier (14) for at least temporary fastening.

10. Manufacturing method according to any of claims 8 or 9, **characterized in that** a carrier substrate of the sensor chip (12) is ground down to a substrate thickness of less than 100 µm, in particular less than 50 µm and preferably less than 30 µm.

11. Manufacturing method according to any of claims 8 to 10, **characterized in that** a tribological protective layer (42) is applied to the underside (46) of the sensor carrier (14).

12. Manufacturing method according to any of claims 8 to 11, **characterized in that** the underside (46) of the sensor carrier (14) is ground flat at least in the area around the recess (16) after embedding of the sensor chip (12).

13. Manufacturing method according to any of claims 8 to 12, **characterized in that** the recess (16) in the carrier substrate is designed step-like in order to provide a deepened connection area (36) on which bond pads (20) are arranged, wherein bonding wires (22) are during bonding preferably laid inside the recess (16) such that they do not protrude above the upper side (44) of the sensor carrier (14).

14. Measuring method using a magnetic field sensor (10, 30, 40, 50) according to any of the aforementioned claims 1 to 7, **characterized in that** a sensor magnet (38) is moved along the underside (46) of the sensor carrier (14), and the measurement signals of the sensor chip (12) are processed and/or evaluated by an evaluation device (32) arranged on the upper side (44) of the sensor carrier (14).

## Revendications

1. Capteur de champ magnétique (10, 30, 40, 50) pour mesurer un champ magnétique variable, notamment pour un capteur de mouvement ou de position, comprenant une puce de détection (12) magnétorésistive et un support de capteur (14) planiforme, portant la puce de détection (12) avec une face supérieure (44) et une face inférieure (46), sachant que la face supérieure (44) du support de capteur (14) présente un évidement (16) sous forme de percée à travers le support de capteur (14), dans lequel est disposée la puce de détection (12), sachant que la puce de détection (12) est contactable électriquement, depuis la face supérieure (44), par le biais des points de connexion prévus sur la puce de détection (12), et que la puce de détection (12) enregistre, via la face inférieure (46), un champ magnétique à mesurer qui est généré par un aimant de capteur (38) générateur qui est guidable le long de la face inférieure (46) du support de capteur (14), sachant que l'évidement (16) est rempli d'une et/ou recouvert par une enveloppe de protection (26) pour la stabilisation mécanique et la passivation de la puce de détection (12), qui se termine aligné à la face supérieure (44) ou dépasse de la face supérieure (44), **caractérisé en ce que** la puce de détection (12) est insérée horizontalement dans l'évidement (16) de sorte qu'un champ magnétique est détectable par la puce de détection (12) sur l'axe x et/ou y dans le plan du support de capteur (14).

2. Capteur de champ magnétique (10, 30, 40, 50) selon la revendication 1, **caractérisé en ce que** l'enveloppe de protection (26) est une enveloppe de protection par enrobage Glob Top.

3. Capteur de champ magnétique (10, 30, 40, 50) selon la revendication 1, **caractérisé en ce que** la puce de détection (12) est placée et fixée sur le support de capteur (14) depuis la face supérieure.

4. Capteur de champ magnétique (10, 30, 40, 50) selon la revendication 1, **caractérisé en ce que** la face inférieure (46) du support de capteur (14) est recouverte d'un film support (24) et/ou d'une couche de protection tribologique (42), sachant que le film support (24) est de préférence une feuille de Kapton.

5. Capteur de champ magnétique (10, 30, 40, 50) selon l'une des revendications précédentes, **caractérisé en ce que** l'évidement (16) est constitué de manière étagée, et présente une zone de connexion en retrait (36) avec des plots de connexion (20) et que, de préférence, des fils de connexion (22) sont guidés à l'intérieur de l'évidement (16) de telle sorte à ne pas sortir de la face supérieure (44) du support de capteur (14).

6. Capteur de champ magnétique (10, 30, 40, 50) selon l'une des revendications précédentes, **caractérisé en ce que** la puce de détection (12) comprend un substrat porteur qui affleure la face inférieure (46) du support de capteur (14) dans l'évidement (16), et que l'épaisseur du substrat porteur est inférieure à 100 µm, notamment inférieure à 50 µm et, de préférence, inférieure à 30 µm.

7. Capteur de champ magnétique (10, 30, 40, 50) selon l'une des revendications précédentes, **caractérisé en ce qu'**une couche de protection tribologique (42) est posée comme couche mécanique sur la face inférieure (46) du support de capteur (14).

8. Procédé de fabrication d'un capteur de champ magnétique (10, 30, 40, 50) selon l'une des revendications précédentes, **caractérisé par** les étapes suivantes :
- Création d'un évidement (16) sous forme d'une percée à travers un support de capteur (14), depuis la face supérieure (44) du support de capteur (14) vers la face inférieure (46) du support de capteur (14) ;
- Fixation au moins temporaire d'une puce de détection (12) dans l'évidement (16) au niveau de la face inférieure (46) du support de capteur (14), sachant que la puce de détection (12) est insérée horizontalement dans l'évidement (16) de sorte qu'un champ magnétique est détecté par la puce de détection (12), sur l'axe x et/ou y dans le plan du support de capteur (14) ;
- Bonding de la puce de détection (12) avec des plots de connexion (20) du support de capteur (14) ;
- Remplissage et/ou recouvrement de l'évidement (16) avec une enveloppe de protection (26) pour la stabilisation mécanique et la passivation de la puce de détection (12) qui soit affleure la face supérieure (44) du support de capteur (14) soit dépasse de la zone d'évidement du support de capteur (14) en s'y superposant.

9. Procédé de fabrication selon la revendication 8, **caractérisé en ce que** la puce de détection (12) est placée et fixée pour une fixation au moins temporaire sur un film support (24), notamment une feuille de Kapton, appliqué au moins temporairement sur la face inférieure (46) du support de capteur (14).

10. Procédé de fabrication selon l'une des revendications 8 ou 9, **caractérisé en ce que** le substrat porteur de la puce de détection (12) est poncé à une épaisseur de substrat inférieure à 100 µm, notamment inférieure à 50 µm et, de préférence, inférieure à 30 µm.

11. Procédé de fabrication selon l'une des revendications 8 à 10, **caractérisé en ce qu'**une couche de protection tribologique (42) est appliquée sur la face inférieure (46) du support de capteur (14).

12. Procédé de fabrication selon l'une des revendications 8 à 11, **caractérisé en ce qu'**après l'enrobage de la puce de détection (12), la face inférieure (46) du support de capteur (14) est rectifiée à plat au moins dans la zone entourant l'évidement (16).

13. Procédé de fabrication selon l'une des revendications 8 à 12, **caractérisé en ce que** l'évidement (16) est constitué de manière étagée dans le substrat porteur pour constituer une zone de connexion (36) en retrait sur laquelle sont disposés des plots de connexion (20), sachant que de préférence lors du bonding, des fils de connexion (22) sont guidés à l'intérieur de l'évidement (16) de telle sorte que ceuxci ne dépassent pas de la face supérieure (44) du support de capteur (14).

14. Procédé de mesure utilisant un capteur de champ magnétique (10, 30, 40, 50) selon l'une des revendications 1 à 7 précédentes, **caractérisé en ce qu'**un aimant de capteur (38) est guidé le long de la face inférieure (46) du support de capteur (14), et que les signaux de mesure de la puce de détection (12) sont préparés et/ ou évalués par un dispositif d'évaluation (32) disposé sur la face supérieure (44) du support de capteur (14).
